# EUROPEAN PATENT APPLICATION

(11) **EP 2 136 391 A1**
(43) Date of publication of application: **23.12.2009**
(21) Application number: 08740167.5
(22) Date of filing: 10.04.2008
(51) Int. Cl.: H01L 21/3065

(54) **DRY ETCHING METHOD**

(30) Priority: 11.04.2007 JP 2007103512
(71) Applicant: ULVAC, INC., Chigasaki-shi Kanagawa 253-8543 (JP)
(72) Inventor: MORIKAWA, Yasuhiro, Susono-shi Shizuoka 410-1231 (JP); SUU, Koukou, Susono-shi Shizuoka 410-1231 (JP)
(74) Representative: Albutt, Anthony John
(86) International application number: PCT/JP2008/057066
(87) International publication number: WO 2008/126891

(57) **Abstract**

[Object] To provide a dry etching method by which generation of a notch in an insulating layer can be suppressed and highly-accurate microfabrication can be realized.

[Solving Means] In a dry etching method according to the present invention, a substrate in which a semiconductor layer (21) is formed on an insulating layer (23) formed of a silicon oxide is prepared, a through-hole (25) is formed in the semiconductor layer (21), and a resin film (27) is formed on side walls of the through-hole (25) and a recessed portion (26) while forming the recessed portion (26) in the insulating layer (23) by etching an area in which the insulating layer (23) is exposed via the through-hole (25). By forming the resin film (27) on the side wall of the recessed portion (26), the side wall of the recessed portion (26) is protected from collision of ions in plasma and generation of a notch in the recessed-portion side wall is suppressed. Furthermore, by forming the resin film (27) on the side wall of the through-hole (25), the side wall of the through-hole (25) is protected from the collision of ions in plasma and a hole shape of the through-hole (25) is prevented from fluctuating.

## Description

### Technical Field

The present invention relates to a dry etching method for a substrate in which a semiconductor layer is formed on an insulating layer.

### Background Art

In recent years, an SOI (Silicon On Insulator) substrate has been used for a production of a semiconductor storage device or a MEMS (Micro-Electro-Mechanical System). The SOI substrate has a structure in which an insulating layer formed of a silicon oxide film is sandwiched by silicon substrates. Further, the silicon substrate positioned on an upper layer side and the intermediate insulating layer are processed by a dry etching (plasma etching) method, thus forming a hole (contact hole) and a groove (trench) having a predetermined shape, or an operating space of a movable element (for example, see Patent Document 1 below).

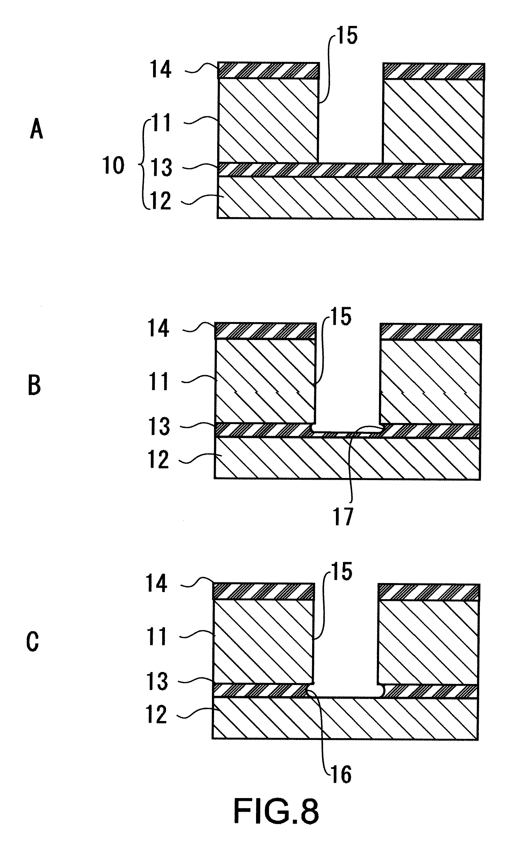

A processing example of the SOI substrate is schematically shown in Figs. 8A to 8C. An SOI substrate 10 includes a first semiconductor layer 11 formed of a silicon substrate on an upper layer side, a second semiconductor layer 12 formed of a silicon substrate on a lower layer side, and an insulating layer 13 that is formed of a silicon oxide film (SiO₂) and intervenes between the first semiconductor layer 11 and the second semiconductor layer 12. As shown in Fig. 8A, formed on a surface of the first semiconductor layer 11 is a pattern layer 14 formed of a silicon oxide film (SiO₂) or the like that is patterned in a predetermined shape. By performing dry etching on the first semiconductor layer 11 with the pattern layer 14 as a mask, a through-hole 15 that passes through the first semiconductor layer 11 is formed.

Subsequently, as shown in Figs. 8B and 8C, a recessed portion 16 is formed in an area in which the insulating layer 13 is exposed via the through-hole 15. At a time of forming the recessed portion 16, dry etching is performed with the first semiconductor layer 11 having the through-hole 15 as a mask. For the formation of the through-hole 15 and the recessed portion 16, for example, a mixed gas of Ar and SF₆ is used as an etching gas.

Patent Document 1: Japanese Patent Application Laid-open No. 2003-203967
Patent Document 2: Japanese Patent Application Laid-open No. 11-219938

### Disclosure of the Invention

### Problems to be solved by the Invention

However, in the conventional dry etching method described above, there is a case where a notch (undercut) 17 is formed at a lower portion of the through-hole 15 (Fig. 8B). It is thought that a main cause of the notch 17 is a charge-up of a bottom portion of the through-hole 15. That is, electrons in plasma remain at the bottom portion of the through-hole 15 due to a substrate bias at a time of etching, positive ions in the plasma are drawn into the bottom portion, and etching of the insulating layer 13 is advanced isotropically, with the result that the notch 17 is generated.

When the notch 17 is generated, a formation width (or diameter) of the recessed portion 16 that is formed in the insulating layer 13 is made larger than that of the through-hole 15. Therefore, for example, in a case where conductor plating is formed on side walls of the through-hole 15 and the recessed portion 16 and interlayer wiring (contact hole) is formed, there is a problem that a break is liable to occur due to a plating failure at a position in which the notch 17 is generated.

In addition, in the conventional dry etching method, because ions in the plasma collide not only with a surface area of the insulating layer 13 exposed from the through-hole 15 but also with the side wall of the through-hole 15 when the insulating layer 13 is etched, a formation width (or diameter) of the through-hole 15 fluctuates along with the formation of the recessed portion 16, resulting in another problem that highly-accurate microfabrication cannot be performed.

In order to prevent a charge-up at the through-hole bottom portion, which is thought to be a cause of the notch, there is known a method of performing a pulse modulation on bias power that is applied to a substrate (see Patent Document 2 above, for example). However, this structure requires installation costs for peripheral equipment such as a pulse generator. In addition, because a size of the notch is changed in accordance with a depth or a formation width (diameter) of the through-hole, a problem that control becomes complicated is involved.

The present invention has been made in view of the above-mentioned problems and it is an object of the present invention to provide a dry etching method by which generation of a notch in an insulating layer can be suppressed and highly-accurate microfabrication can be realized.

### Means for solving the Problems

A dry etching method according to an embodiment of the present invention includes preparing a substrate in which a semiconductor layer is formed on an insulating layer formed of a silicon oxide.
A through-hole is formed in the semiconductor layer. A resin film is formed on side walls of the through-hole and a recessed portion while forming the recessed portion in the insulating layer by etching an area in which the insulating layer is exposed via the through-hole.

### Best Modes for Carrying Out the Invention

A dry etching method according to an embodiment of the present invention includes preparing a substrate in which a semiconductor layer is formed on an insulating layer formed of a silicon oxide.
A through-hole is formed in the semiconductor layer. A resin film is formed on side walls of the through-hole and a recessed portion while forming the recessed portion in the insulating layer by etching an area in which the insulating layer is exposed via the through-hole.

In the dry etching method, the resin film is formed on the side walls of the through-hole and the recessed portion while forming the recessed portion in the insulating layer. By forming the resin film on the side wall of the recessed portion, the side wall of the recessed portion is protected from collision of ions in plasma and generation of a notch on the recessed-portion side wall is suppressed. Furthermore, by forming the resin film on the side wall of the through-hole, the side wall of the through-hole is protected from the collision of ions in plasma and a hole shape of the through-hole is prevented from fluctuating. Accordingly, highly-accurate microfabrication with respect to the substrate can be realized.

In the dry etching method, in the forming of the recessed portion, a gas containing at least a fluorocarbon-based gas can be used as an etching gas. As this type of gas, a fluorocarbon-based gas alone, or a mixed gas in which a fluorocarbon-based gas is added to Ar, Xe, Kr, H₂, N₂, or the like can be used. Accordingly, it is possible to form the resin film on the side walls of the through-hole and the recessed portion in the process of forming the recessed portion in the insulating layer. Examples of the fluorocarbon-based gas include CF₄, C₃F₈, C₄F₈, and CHF₃.

In the dry etching method, an etching pressure can be set to 0.1 Pa or more to 1.0 Pa or less.
Accordingly, the resin film can be formed stably.

In the dry etching method, a proportion of the fluorocarbon-based gas in the etching gas can be set to 20% or more.
Accordingly, a relatively-high deposition rate can be obtained.

In the dry etching method, a temperature of the substrate can be set to 150ºC or less.
Accordingly, a deposition rate of the resin film can be increased.

In the dry etching method, a thickness of the resin film formed on the side wall of the recessed portion can be set to 0.1 µm or more.
Accordingly, the side walls of the through-hole and the recessed portion can be protected from a collision action of incoming ions when the recessed portion is formed.

In the dry etching method, the recessed portion can be formed by a magnetic neutral loop discharge etching method.
By employing the magnetic neutral loop discharge etching method, desired etching characteristics can be obtained under a relatively-low pressure of 1 Pa or less.

The dry etching method may further include removing the resin film after the recessed portion is formed.
Accordingly, a contact hole constituted of the through-hole and the recessed portion can be formed in the substrate.

In the dry etching method, the resin film can be removed by ashing processing using oxygen plasma.
Accordingly, it is possible to easily remove the resin film by only replacing the etching gas with an ashing gas.

Hereinafter, embodiments of the present invention will be described with reference to the drawings.

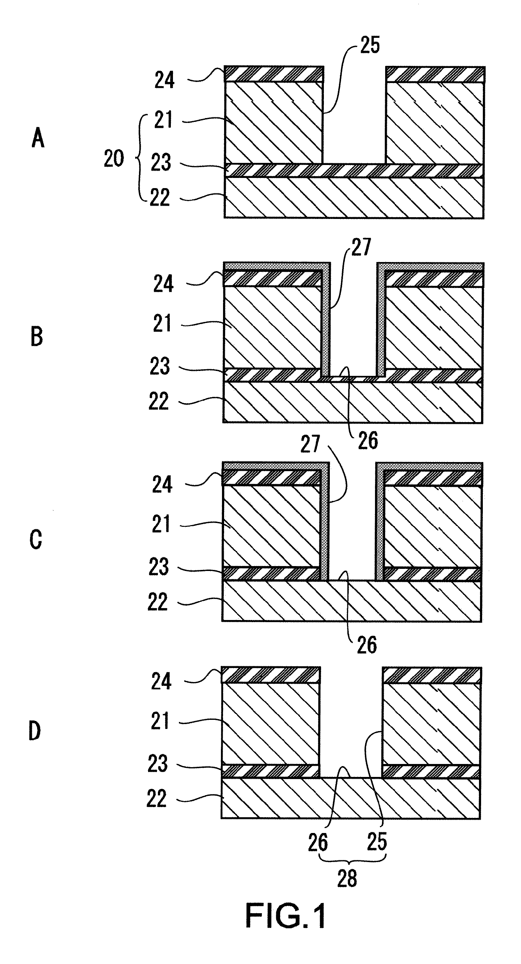

Figs. 1A to 1D are schematic process cross-sectional views of a main portion for explaining a dry etching method according to an embodiment of the present invention.

In this embodiment, there is used, as an etching target substrate, a substrate 20 having an SOI structure in which a first semiconductor layer 21 formed of a silicon substrate, a second semiconductor layer 22 formed of a silicon substrate, and an insulating layer 23 that is formed of a silicon oxide film (SiO₂) and is formed between the first and second semiconductor layers 21 and 22 are included.

Each of the first semiconductor layer 21 and the second semiconductor layer 22 can be structured with a silicon substrate on which various elements are formed in advance. In this embodiment, the first semiconductor layer 21 and the insulating layer 23 are subjected to etching processing sequentially and a contact hole 28 is formed in the substrate 20. For example, a wiring layer is provided to the second semiconductor layer 22 at a position corresponding to a position where the contact hole 28 is formed. Hereinafter, a method of forming the contact hole 28 using the present invention will be descried.

First, the substrate 20 structured as described above is prepared. The substrate 20 is structured by bonding the first semiconductor layer 21 and the second semiconductor layer 22 with the insulating layer 23 being sandwiched therebetween. A thickness of the first semiconductor layer 21 is 250 µm, a thickness of the second semiconductor layer 22 is 50 µm, and a thickness of the insulating layer 23 is 1.0 µm. The insulating layer 23 may be formed on the first semiconductor layer 21 side or the second semiconductor layer 22 side at first. Further, the insulating layer 23 may be formed by forming an insulating film on each of the first and second semiconductor layers 21 and 22 in advance and bonding the insulating films to each other.

A known method can be employed for the bonding of the first semiconductor layer 21 and the second semiconductor layer 22. Specifically, there are applicable a room-temperature bonding method such as anodic bonding, a substrate bonding method that involves activation processing of a bonding surface by ion irradiation under a reduced-pressure atmosphere, and the like. In those substrate bonding methods, it is possible to bond substrates without using an adhesive.

A mask pattern layer 24 for forming a contact hole is formed in advance on the substrate 20. The mask pattern layer 24 is formed by patterning a silicon oxide film (SiO₂) that is formed on a surface of the first semiconductor layer 21 in a predetermined shape by a photolithography technique. The silicon oxide film may be a thermal oxidation film formed on the surface of the first semiconductor layer 21 or may be a deposition film formed by a plasma CVD method or the like.

As shown in Fig. 1A, dry etching (reactive ion etching) is first performed on the first semiconductor layer 21 with the mask pattern layer 24 as a mask and a through-hole 25 is formed inside the first semiconductor layer 21. In this embodiment, the through-hole 25 is formed in a diameter of 20 µm, but is not limited thereto. The diameter of the hole may be much smaller. As an etching gas, SF₆ or a mixed gas of SF₆ and a noble gas or an inert gas such as Ar is used.

Next, as shown in Figs. 1B and 1C, a recessed portion 26 is formed in an area in which the insulating layer 23 is exposed via the through-hole 25. When the recessed portion 26 is formed, dry etching (reactive ion etching) is performed with the first semiconductor layer 21 having the through-hole 25 as a mask. In this embodiment, for the formation of the recessed portion 26, a mixed gas of C₄F₈ and Ar is used as an etching gas.

In this embodiment, a process of forming a resin film 27 on side walls of the through-hole 25 and the recessed portion 26 is performed simultaneously while forming the recessed portion 26. The resin film 27 is made of a fluorine-based resin generated by a decomposition reaction of the etching gas and is simultaneously formed on the side wall of the recessed portion 26 and the side wall of the through-hole 25. It should be noted that though a similar resin film may be formed at a bottom portion of the recessed portion 26, the resin film is removed by ions in plasma that are drawn into the substrate 20 by high-frequency bias power that is applied to the substrate 20 during etching processing. That is, the ions etch the recessed portion 26 in a depth direction thereof while removing the resin film that has adhered to the bottom portion of the recessed portion 26. The formation of the recessed portion 26 is ended at a time point when the bottom portion of the recessed portion 26 reaches a surface of the second semiconductor layer 22.

According to this embodiment, by causing the resin film 26 that is formed simultaneously with the formation of the recessed portion 26 to function as a side wall protection film of the through-hole 25 and the recessed portion 26, the side wall of the recessed portion 26 is protected from the collision of the ions in plasma and generation of a notch on the side wall of the recessed portion 26 is suppressed. Further, by forming the resin film 26 on the side wall of the through-hole 25, the side wall of the through-hole 26 is protected from the collision of the ions in plasma and a hole shape of the through-hole 26 is prevented from fluctuating. As described above, highly-accurate microfabrication with respect to the substrate 20 can be realized.

A thickness of the resin film 27 that is formed on the side walls of the through-hole 25 and the recessed portion 26 is not limited in particular, but requires at least a thickness that can protect the side walls of the through-hole 25 and the recessed portion 26 from a collision action of the incoming ions when the recessed portion 26 is formed. Specifically, the thickness of the resin film 27 is set to 0.1 µm or more.

After the recessed portion 26 is formed, a process of removing the resin film 26 is performed as shown in Fig. 1C. For the removal of the resin film 26, ashing processing in an oxide atmosphere can be performed. Accordingly, the contact hole 28 constituted of the through-hole 25 and the recessed portion 26 is formed with respect to the substrate 20.

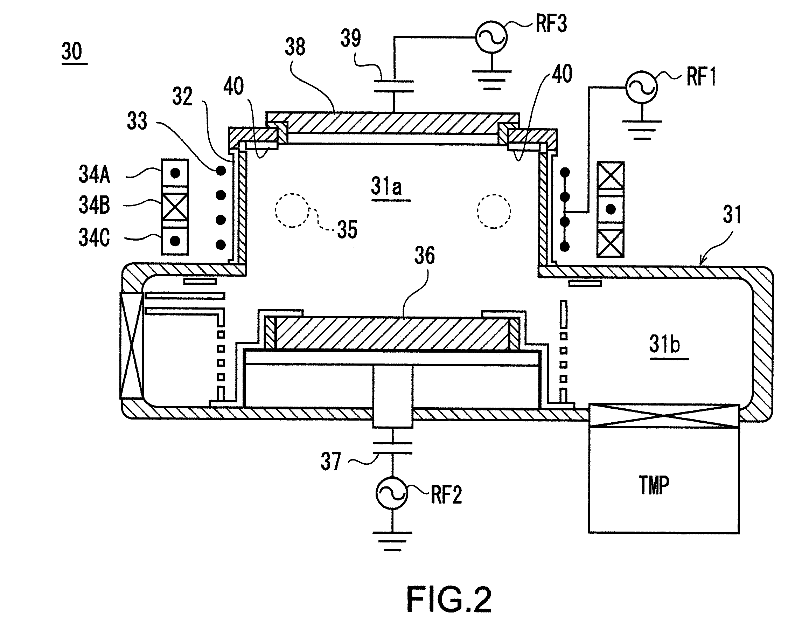

Fig. 2 is a schematic structural view of a dry etching apparatus 30 that is used in the dry etching method for the substrate 20 described above.
The dry etching apparatus 30 is structured as an NLD (Magnetic Neutral Loop Discharge) plasma etching apparatus.

The dry etching apparatus 30 includes a vacuum chamber 31. A vacuum pump such as a turbo-molecular pump (TMP) is connected to the vacuum chamber 31 and an inside of the vacuum chamber 31 is evacuated to a predetermined degree of vacuum.

The vacuum chamber 31 includes a plasma generation portion 31a and a substrate processing portion 31b. In a circumference of a cylindrical wall 32 that is made of quartz and constitutes the plasma generation portion 31a, there are arranged a high-frequency coil (antenna) 33 for plasma generation that is connected to a first high-frequency power source RF1 and three magnetic coils 34A, 34B, and 34C that are arranged on an outer circumferential side of the high-frequency coil 33.

The magnetic coil 34A and the magnetic coil 34B are supplied with current in the same direction and the magnetic coil 34B is supplied with current in the opposite direction of the other magnetic coils 34A and 34C. As a result, a magnetic neutral line 35 is formed in a ring shape in the plasma generation portion 31a and, by an induction electric field being applied by the high-frequency coil 33 along the magnetic neutral line 35, discharge plasma is formed.

In an NLD etching apparatus, in particular, a formation position and a size of the magnetic neutral line 35 can be adjusted depending on an amount of current that is to be fed to the magnetic coils 34A to 34C. That is, when current fed to the magnetic coils 34A, 34B, and 34C are represented by I_{A}, I_{B}, and I_{C}, respectively, the formation position of the magnetic neutral line 35 is lowered toward the magnetic coil 34C side in a case where IA > IC is satisfied, and conversely, the formation position of the magnetic neutral line 35 is raised toward the magnetic coil 34A side in a case where IA < IC is satisfied. Moreover, when an amount of current IB fed to the intermediate magnetic coil 34B is increased, a ring diameter of the magnetic neutral line 35 becomes small and simultaneously a magnetic filed gradient becomes gentle at a zero position of the magnetic filed. By utilizing those characteristics, it is possible to achieve optimization of a plasma density distribution.

On the other hand, a stage 36 that supports the substrate 20 (Figs. 1) is placed in the substrate processing portion 31b of the vacuum chamber 31. Though not being illustrated, the stage 36 incorporates a temperature adjustment mechanism that is capable of adjusting a temperature of the substrate 20 placed on an upper surface thereof. The stage 36 is connected to a second high-frequency power source RF2 as a bias power source via a capacitor 37. Further, a top panel 38 that is formed at an upper portion of the plasma generation portion 31a as a counter electrode of the stage 36 is connected with a third high-frequency power source RF3 via a capacitor 39.

In the vicinity of the top panel 38, a gas introduction pipe 40 for introducing a process gas into the vacuum chamber 31 is installed. The process gas includes various gases that perform etching processing on the substrate 20, and an etching gas for performing etching processing on the first semiconductor layer 21 (mixed gas of SF₆ gas and Ar gas), an etching gas for performing etching processing on the insulating layer 23 (mixed gas of C₄F₈ gas and Ar gas), an oxygen gas for removing the resin film 27 by ashing, and the like are applicable.

In the dry etching apparatus 30 of this embodiment as structured above, the etching process of the first semiconductor layer 21 (formation process of through-hole 25), the etching process of the insulating layer 23 (formation process of recessed portion 26), and the removal process of the resin film 27 are continuously performed on the substrate 20 placed on the stage 36 by replacing gases.

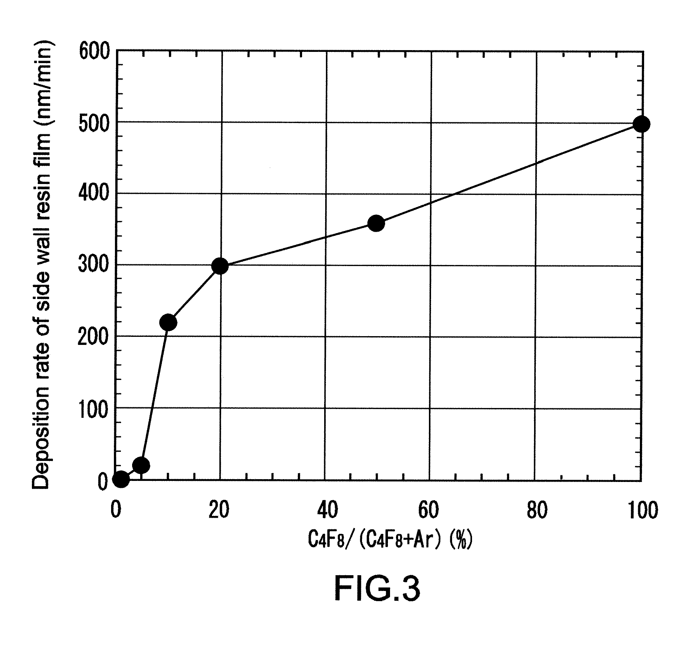

Next, Fig. 3 shows a relationship between a proportion of a C₄F₈ gas in the entire etching gas used in the forming process of the recessed portion 26 (mixture ratio) and a deposition rate of the resin film 27 that is formed on the side wall of the recessed portion 26 (through-hole 25). As shown in Fig. 3, the deposition rate of the resin film 27 depends on the mixture ratio of the C₄F₈ gas. In particular, it is found that a deposition rate of 200 [nm/min] is obtained when a content of the C₄F₈ gas is 10% or more and a deposition rate of about 300 [nm/min] or more is obtained when the content of the C₄F₈ gas is 20% or more. The deposition rate of the resin film 27 with respect to the side wall also relates to a type of a contained fluorocarbon-based gas. For example, it is ascertained that in a case of a C₃F₈ gas, a deposition rate of 300 [nm/min] (0.3 [µm/min]) is obtained at a mixture ratio of 0.2 to 0.3%.

The deposition rate of the resin film 27 formed on the side walls of the through-hole 25 and the recessed portion 25 also depends on a pressure of the vacuum chamber and a substrate temperature at a time of etching processing, in addition to the mixture ratio of the fluorocarbon-based gas in the etching gas described above.

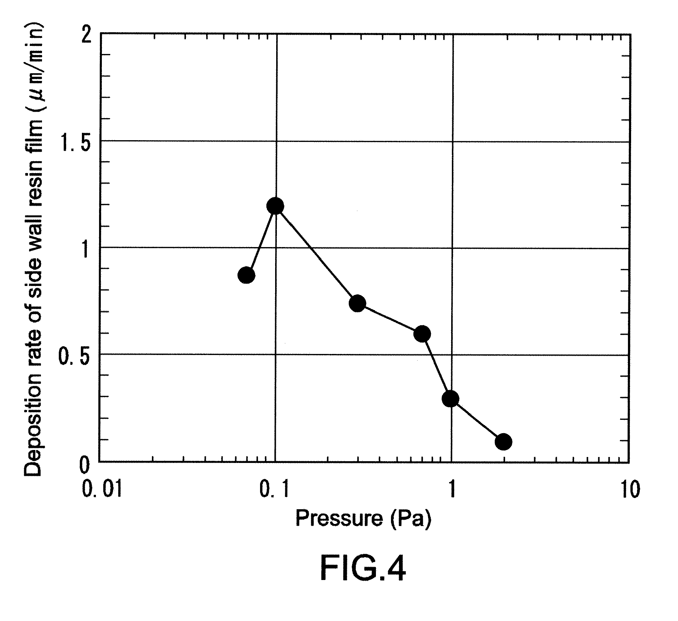

Fig. 4 shows a relationship between a pressure in a chamber and the deposition rate of the resin film 27. It is found that a deposition rate of 0.3 [µm/min] or more is obtained at a pressure in a chamber of 1.0 Pa or less. The deposition rate is reduced when the pressure is below 0.1 Pa because an amount of the etching gas is reduced. Therefore, by performing etching processing on the insulating layer 23 at a pressure in a chamber of 0.1 Pa or more to 1.0 Pa or less, or 0.1 Pa or more to 0.7 Pa or less, it becomes possible to achieve stable deposition of the resin film 27.

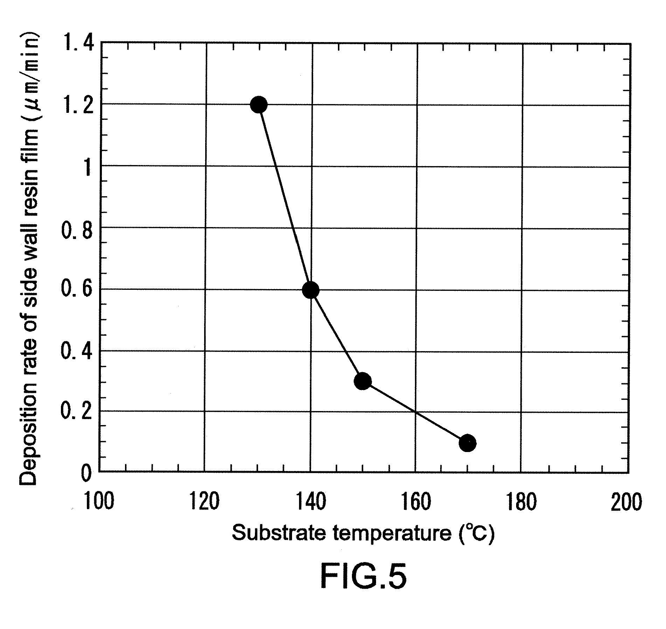

On the other hand, Fig. 5 shows a relationship between a substrate temperature and the deposition rate of the resin film 27. It is found that the deposition rate increases along with lowering of a substrate temperature. It has been ascertained that when a substrate temperature is 150ºC or less, a deposition rate of 0.3 [µm/min] or more is obtained. It is thought that this is because an amount of absorption of active species that contribute to formation of the resin film 27 to the substrate increases as the substrate temperature is lower.

Further, according to this embodiment, as shown in Figs. 1B and 1C, since the resin film 27 is formed not only on the side walls of the through-hole 25 and the recessed portion 26 but also on a surface of the mask pattern layer 24 similarly, it is possible to avoid etching of the mask pattern layer 24 that is formed of the same silicon oxide film (SiO₂) as the insulating layer 23 when the recessed portion 26 is formed in the insulating layer 23.

In this case, the number of ions entering the surface of the mask pattern layer 24 is larger than the number of ions entering the side walls of the through-hole 25 and the recessed portion 26 and accordingly an difference in etching rate of the resin film 27 is caused. However, because the deposition rate of the resin film 27 is higher on the surface of the mask pattern layer 24 than on the side walls of the through-hole 25 and the recessed portion 26, the mask pattern layer 24 is effectively protected from the collision of ions.

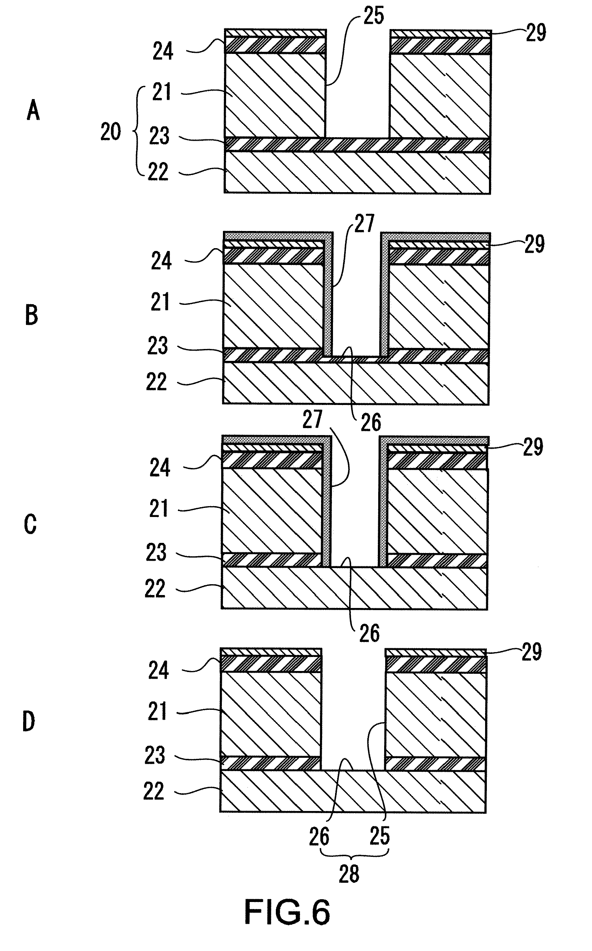

Accordingly, the present invention is also effective in etching of the substrate 20 on which a metal wiring layer is formed in advance on the mask pattern layer 24. Figs. 6A to 6D schematically show an application example thereof. It should be noted that in the figures, portions corresponding to those of Figs. 1 are denoted by the same symbols and detailed descriptions thereof are omitted.

As shown in Fig. 6A, a metal layer 29 is formed on the surface of mask pattern layer 24 for forming the through-hole 25 in the first semiconductor layer 21. Also in this example, as shown in Fig. 6C, the resin film 27 is formed on a surface of the metal layer 29 and the side walls of the through-hole 25 and the recessed portion 26 simultaneously with the formation of the recessed portion 26. Accordingly, because a film reduction of the metal layer 29 due to etching can be prevented effectively, reliability of the wiring layer 29 is ensured.

Hereinabove, the embodiment of the present invention has been described, but the present invention is not limited thereto as a matter of cause and various modifications can be made based on the technical idea of the present invention.

For example, though the resin film 27 that is formed on the side walls of the through-hole 25 and the recessed portion 26 is removed after the contact hole 28 is formed in the embodiment above, the resin film 27 may remain in the substrate 20 as an insulating film without removing the resin film 27.

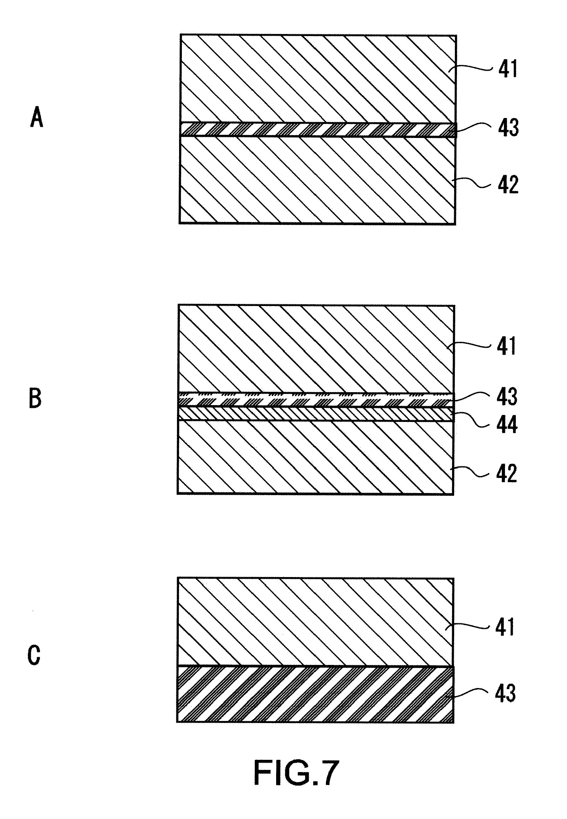

On the other hand, Figs. 7A to 7C each show a structural example of a substrate to which the dry etching method of the present invention is applied. As in the embodiment above, Fig. 7A shows a substrate structure in which a pair of semiconductor substrates 41 and 42 sandwich an insulating layer 43. In this case, after the first semiconductor layer 41 as the upper layer and the insulating layer 43 are processed, etching may be performed on the second semiconductor layer 42 as the lower layer.

Fig. 7B shows a substrate structure that includes a metal layer 44 between the second semiconductor layer 42 and the insulating layer 43. In this case, by performing conductivity-imparting processing of conductor plating or the like after a contact hole that passes through the first semiconductor layer 41 and the insulating layer 43 is formed, it is possible to form an interlayer connection layer that electrically communicates between the first semiconductor layer 41 and the second semiconductor layer 42.

Fig. 7C shows a substrate having a two-layered structure in which the first semiconductor layer 41 is formed on the insulating layer 43. In this case, the insulating layer 23 is constituted of a glass substrate (silicon oxide) of quartz or the like and has a function of supporting the semiconductor layer 41. The insulating layer 23 can be used as, for example, a casing component of an MEMS component.

Moreover, in the embodiment described above, the NLD etching apparatus has been used as the dry etching apparatus, but without being limited thereto, an ICP (inductively coupled plasma) dry etching apparatus and a CCP (Capacitively Coupled Plasma) dry etching apparatus may be used.

### Brief Description of Drawings

[Figs. 1] Process cross-sectional views of a main portion, for explaining a dry etching method according to an embodiment of the present invention.
[Fig. 2] Schematic structural view of a dry etching apparatus used in the embodiment of the present invention.
[Fig. 3] Diagram showing a relationship between a gas composition of an etching gas for an insulating layer and a deposition rate of a resin film.
[Fig. 4] Diagram showing a relationship between a pressure in a chamber when the insulating layer is etched and the deposition rate of the resin film.
[Fig. 5] Diagram showing a relationship between a substrate temperature when the insulating layer is etched and the deposition rate of the resin film.
[Figs. 6] Process cross-sectional views of a main portion, for explaining a dry etching method according to another embodiment of the present invention.
[Figs. 7] Schematic cross-sectional views each showing a structural example of a substrate applied to the present invention.
[Figs. 8] Process cross-sectional views of a main portion, for explaining a conventional dry etching method.

### Description of Symbols

- 20: substrate
- 21: first semiconductor layer
- 22: second semiconductor layer
- 23: insulating layer
- 24: mask pattern layer
- 25: through-hole
- 26: recessed portion
- 27: resin film
- 28: contact hole
- 29: metal layer
- 30: dry etching apparatus

## Claims

1. A dry etching method, comprising:
preparing a substrate in which a semiconductor layer is formed on an insulating layer formed of a silicon oxide;
forming a through-hole in the semiconductor layer; and
forming a resin film on side walls of the through-hole and a recessed portion while forming the recessed portion in the insulating layer by etching an area in which the insulating layer is exposed via the through-hole.

2. The dry etching method according to claim 1,
wherein in the forming of the recessed portion, a gas containing at least a fluorocarbon-based gas is used as an etching gas.

3. The dry etching method according to claim 2,
wherein an etching pressure is 0.1 Pa or more to 1.0 Pa or less.

4. The dry etching method according to claim 3,
wherein a proportion of the fluorocarbon-based gas in the etching gas is 20% or more.

5. The dry etching method according to claim 4, wherein the fluorocarbon-based gas is C₄F₈.

6. The dry etching method according to claim 3,
wherein a temperature of the substrate is 150ºC or less.

7. The dry etching method according to claim 3,
wherein a thickness of the resin film formed on the side wall of the recessed portion is 0.1 µm or more.

8. The dry etching method according to claim 1,
wherein the recessed portion is formed by a magnetic neutral loop discharge etching method.

9. The dry etching method according to claim 1, further comprising
removing the resin film after the recessed portion is formed.

10. The dry etching method according to claim 9,
wherein the resin film is removed by ashing processing using oxygen plasma.
